# EUROPÄISCHE PATENTSCHRIFT

(11) **EP 4 274 923 B1**
(45) Veröffentlichungstag und Bekanntmachung des Hinweises auf die Patenterteilung: **26.02.2025**
(21) Anmeldenummer: 21840434.1
(22) Anmeldetag: 28.12.2021
(51) Int. Cl.: C30B 11/00, C30B 11/02, C30B 11/14, C30B 29/20

(54) **VORRICHTUNG ZUM ZÜCHTEN EINES KÜNSTLICH HERGESTELLTEN SAPHIR-EINKRISTALLS**
DEVICE FOR GROWING AN ARTIFICIALLY PRODUCED SAPPHIRE SINGLE CRYSTAL
DISPOSITIF POUR FAIRE CROÎTRE UN MONOCRISTAL DE SAPHIR PRODUIT DE MANIÈRE ARTIFICIELLE

(30) Priorität: 29.12.2020 AT 511442020
(43) Veröffentlichungstag der Anmeldung: 15.11.2023
(73) Patentinhaber: FAMATEC GmbH, 4060 Leonding (AT)
(72) Erfinder: BARBAR, Ghassan, 57290 Neunkirchen (DE); EBNER, Robert, 4060 Leonding (AT); PARK, Jong Kwan, 4060 Leonding (AT); SEN, Gourav, 4060 Leonding (AT)
(74) Vertreter: Burger, Hannes
(86) Internationale Anmeldenummer: PCT/AT2021/060487
(87) Internationale Veröffentlichungsnummer: WO 2022/140806

(56) Entgegenhaltungen:
- EP-A1- 2 574 689
- WO-A1-2014/028831
- WO-A1-2014/148156
- CN-U- 203 393 259
- JP-A- 2006 273 630
- JP-A- H01 145 392
- US-A1- 2011 253 033
- US-A1- 2020 238 370

## Beschreibung

Die Erfindung betrifft eine Vorrichtung zum Züchten eines oder mehrerer künstlich hergestellter Saphir-Einkristalle in einer Kammer, umfassend
- einen oder mehrere dünnwandige Tiegel wie beispielsweise in WO201567552A1 beschrieben, mit je einer Tiegelwand, welche Tiegelwand einen offenen ersten Endbereich und einen in Richtung einer Längsachse davon beabstandet angeordneten bodenseitigen zweiten Endbereich aufweist, wobei von der Tiegelwand im Querschnitt bezüglich der Längsachse gesehen eine Tiegelwand-Innenfläche und in einer Tiegelwanddicke davon beabstandet eine Tiegelwand-Außenfläche definiert ist,
- je einen Tiegelboden, welcher Tiegelboden im bodenseitigen zweiten Endbereich angeordnet ist, und
- wobei von der Tiegelwand und dem Tiegelboden ein Aufnahmeraum zur Bildung des Einkristalls definiert ist.

Eine Vorrichtung der eingangs genannten Art ist aus der JP H01145392 A bekannt geworden. Weitere einschlägige Vorrichtungen sind in der WO2014/148156 A1, der CN 203393259 U sowie der US2011/253033 A1 beschrieben. Die Herstellung von großen Einkristallen, wie sie z.B. zur Herstellung von Wafern eingesetzt werden, ist aus dem Stand der Technik, beispielsweise der KR 10 2017-0026734 A, bekannt. Bekanntlich sind die Qualitätsanforderungen an diese Kristalle sehr hoch, sodass im Stand der Technik unterschiedlichste Verfahren und Vorrichtungen zu deren Herstellung beschrieben wurden. Eine Verfahrensart sieht dabei die Bereitstellung und das Aufschmelzen des "Rohmaterials" in einem Tiegel vor. Das Einkristall wird dann durch kontrollierte Abkühlung der Schmelze im Tiegel, in den Tiegeln selbst erzeugt. Die hierfür verwendeten Vorrichtungen sind unterschiedlichst ausgestaltet. Beispielsweise beschreibt die US 2013/152851 A1 eine Vorrichtung zur Herstellung eines Si-Einkristalls, die eine Isolierkammer aufweist, in der der Tiegel/die Tiegel und Heizelemente neben und oberhalb des Tiegels/der Tiegel angeordnet sind. Zwischen dem oberen Heizelement und dem Tiegel/den Tiegeln ist weiter ein Reflektor angeordnet um aus dem Tiegel/den Tiegeln abgestrahlte Wärmeenergie wieder in den Tiegel/die Tiegel zu reflektieren und damit die Energieeffizienz der Einkristallzüchtung zu verbessern.

Die WO 2015 067552 A1 beschreibt eine Vorrichtung zur Herstellung eines oder mehrere Saphir-Einkristalls, umfassend eine Kammer, einen darin angeordneten Tiegel, in dem/in den die Aluminiumoxidschmelze enthalten ist, eine Heizung, die außerhalb des Tiegels angeordnet ist, um den Tiegel/Tiegel zu erhitzen, und eine Wärmeversorgungseinheit, die über einem im Tiegel wachsenden Einkristall angeordnet ist, um dem Einkristall Wärme zuzuführen. Auch bei dieser Vorrichtung ist ein Reflektor vorgesehen, der die in der Kammer erzeugte Wärme zu einer Oberfläche des Einkristalls reflektiert. Ein Nachteil herkömmlicher Lösungen besteht darin, dass sich im Bereich von sich entlang der Höhe der Tiegelwand erstreckenden Schweißnähten während des Kristallwachstums Fehlstellen im Kristall ausbilden, die nach Fertigstellung eines Ingots durch Schleifen desselben entfernt werden müssen.

Aufgabe der vorliegenden Erfindung war es, einen qualitativ sehr hochwertigen Einkristall zu erzeugen, die Ausbeute zu erhöhen und in Summe den Energieverbrauch pro hergestellten Einkristall zu reduzieren.

Diese Aufgabe wird durch eine Vorrichtung der eingangs genannten Art erfindungsgemäß durch die Merkmale des Anspruchs 1 gelöst.

Durch die erfindungsgemäße Lösung kann vermieden werden, dass sich entlang einer Unstetigkeitsstelle in der Tiegelwand, wie beispielsweise einer Schweißnaht, Fehlstellen in dem Einkristall während des Kristallwachstums bilden. Dadurch wird die Ausbeute bezogen auf eine Querschnittsfläche eines Ingots größer, da weniger bis gar keine Fehlstellen aufweisende Bereiche des Ingots/der Ingots abgetragen werden müssen, wie dies bei herkömmlichen Lösungen erforderlich ist und es werden größere Wafer erhalten. Somit wird er Energiebedarf bezogen auf die Fläche von aus dem Ingot/den Ingots geschnittenen Wafern ebenfalls reduziert.

Mit der erfindungsgemäßen Lösung können auch mehrere Kristalle gleichzeitig in einem Ofen gezüchtet werden, indem mehrere Tiegel in dem Ofen angeordnet werden.

Gemäß einer bevorzugten Variante der Erfindung weist die Tiegelwand-Innenfläche über ihre ganze Fläche eine gleichartige Oberflächenausbildung auf. Durch diese Variante wird ein störungsfreies Kristallwachstum auch in in radialer Richtung gesehen oberflächennahen Bereichen des Kristalls begünstigt.

Gemäß einer weiteren vorteilhaften Ausführungsform der Erfindung kann es vorgesehen sein, dass die Tiegelwand in sich ringförmig geschlossen und nahtlos ausgebildet ist. Durch den Verzicht auf eine Schweißnaht kann eine von Unstetigkeitsstellen freie Tiegelwand erreicht werden, wodurch ein störstellenfreies Kristallwachstum begünstigt wird.

Eine Weiterbildung der Erfindung besteht darin, dass die Tiegelwand über ihre gesamte Erstreckung einen gleichartigen strukturellen Aufbau aufweist.

Gemäß einer besonders bevorzugten Ausführungsform kann die Tiegelwand aus Iridium (Ir), Wolfram (W) oder Molybdän (Mo) hergestellt sein.

Zur Herstellung einer besonders homogenen Tiegelwand hat es sich als vorteilhaft erwiesen, dass die Tiegelwand durch ein Schleudergussverfahren hergestellt ist.

Die Energieeffizienz des Prozesses lässt sich dadurch verbessern, dass der Tiegel nach oben hin offen ist und über dem Tiegel zumindest ein oberes Heizelement angeordnet ist, wobei zwischen dem oberen Heizelement und dem Tiegel ein Wärmediffusorelement zur Erzeugung einer gleichmäßigen Wärmeverteilung angeordnet ist. Diese Variante ermöglicht ein direktes Beheizen des Tiegelinneren, wodurch ein besonders effektiver Wärmeeintrag in die Schmelze bzw. das Basismaterial ermöglicht wird.

Qualitativ besonders hochwertige Kristalle lassen sich dadurch erzielen, dass eine kristallographische c-Achse des Keimkristalls entsprechend einer sich in Richtung der Höhe der Tiegelwand erstreckende Längsachse des Tiegels ausgerichtet ist.

Die Qualität des Kristalls lässt sich dadurch weiter verbessern, dass der Keimkristall im Wesentlichen scheibenförmig ausgebildet ist,
- eine erste Flachseite und eine zweite Flachseite aufweist;
- eine Längsmittelachse aufweist, welche Längsmittelachse in Richtung von der ersten Flachseite zur zweiten Flachseite ausgebildet ist, wobei die c-Achse des Keimkristalls mit der Längsmittelachse des Keimkristalls zusammenfällt.

Zum besseren Verständnis der Erfindung wird diese anhand der nachfolgenden Figuren näher erläutert.

Es zeigen jeweils in stark vereinfachter, schematischer Darstellung:
- Fig. 1: ein erstes, nicht erfindungsgemäßes Beispiel einer Vorrichtung zum Züchten eines künstlich hergestellten Saphir-Kristalls, in Ansicht geschnitten;
- Fig. 2: eine zweite mögliche Ausbildung einer Vorrichtung zum Züchten eines künstlich hergestellten Saphir-Kristalls, in Ansicht geschnitten;
- Fig. 3: ein drittes Ausführungsbeispiel einer Vorrichtung zum Züchten eines künstlich hergestellten Saphir-Kristalls, in Ansicht geschnitten.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

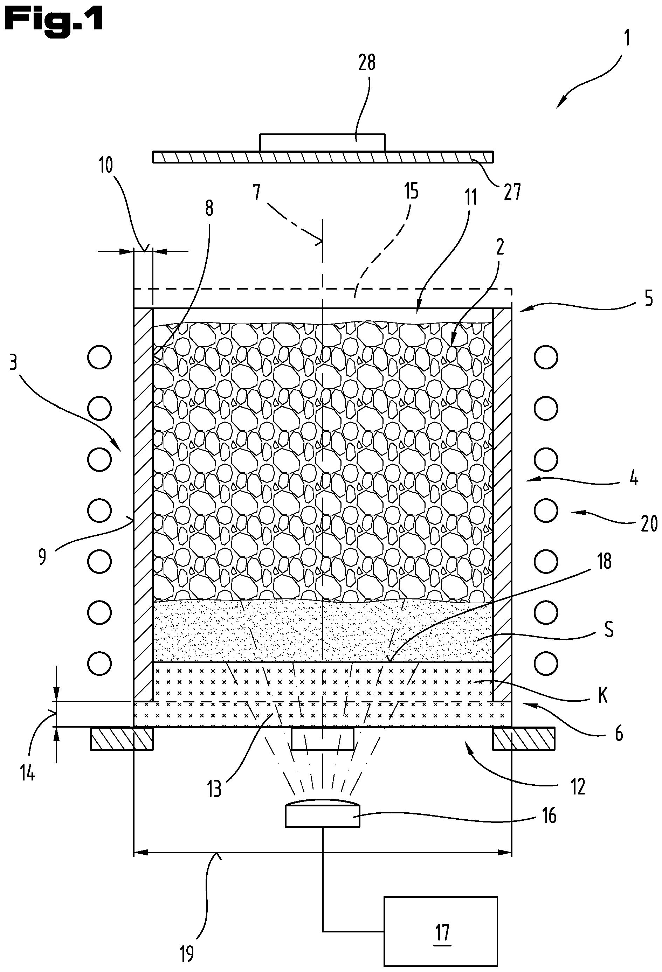

In der Fig. 1 ist ein erstes, nicht erfindungsgemäßes Beispiel einer Vorrichtung 1 gezeigt, welche zum Züchten eines Kristalls, insbesondere eines künstlich hergestellten Saphir-Kristalls, dient bzw. dazu ausgebildet ist. Saphir hat die chemische Formel Al₂O₃ und kommt in der Natur vor und wird unter anderem als Schmuckstein oder dergleichen verwendet.

Die synthetische oder künstliche Herstellung erfolgt ausgehend von einem sogenannten Basismaterial 2, welches eine stückige, körnige bis hin zu einer pulverförmigen Struktur aufweisen kann. Es können auch größere Stücke zur Erreichung einer besseren Fülldichte verwendet werden. Das Basismaterial 2 wird in eine allgemein als Tiegel 3 bezeichnete Aufnahmevorrichtung oder Aufnahmegefäß eingebracht und dort mittels Wärmezufuhr in bekannter Weise aufgeschmolzen.

Die Schmelze, welche nachfolgend mit dem Buchstaben "S" bezeichnet wird, wird abgekühlt und dabei erfolgt die Erstarrung und Bildung des Kristalls "K". Bei einem derartigen Kristall "K" handelt es sich bevorzugt um eine Einkristall-Form von Aluminiumoxid (Al₂O₃). Der synthetisch hergestellte Saphir-Kristall "K" weist einen Härtewert von 9 auf der Mohs-Skala auf. Darüber hinaus weisen daraus hergestellte Produkte, wie z.B. Wafer, Uhrgläser, Gehäuse, Leuchtdioden oder dergleichen, eine hohe Kratzfestigkeit auf. Bevorzugt werden Kristalle "K" mit glasklaren Eigenschaften oder aber auch je nach Zusatzstoff mit farbigem Aussehen gebildet.

Die Vorrichtung 1 umfasst eine Tiegelwand 4, welche ihrerseits einen ersten Endbereich 5 und einen davon beabstandet angeordneten zweiten Endbereich 6 aufweist. Zwischen den beiden Endbereichen 5 und 6 erstreckt sich eine Längsachse 7. Der Tiegel 3 ist in einem Ofen angeordnet und kann mittels Heizelementen erwärmt werden. Es sei an dieser Stelle der Vollständigkeit halber erwähnt, dass die Vorrichtung 1 noch weitere Elemente umfasst, wie z.B. eine Steuer- und/oder Regeleinheit, etc. Da diese aber dem Stand der Technik entsprechen können, wird in dieser Beschreibung nicht weiter darauf eingegangen, sondern an den hierfür einschlägigen Stand der Technik verwiesen.

Bei diesem Ausführungsbeispiel ist der erste Endbereich 5 des Tiegels 3 offen ausgebildet. Der zweite Endbereich 6 bildet bei lotrechter Ausrichtung der Längsachse 7 den bodenseitigen Endabschnitt aus und ist gänzlich offen oder zu einem überwiegenden Anteil offen ausgebildet. Die Tiegelwand 4 ist grundsätzlich rohrförmig ausgebildet und kann die unterschiedlichsten Querschnittformen bezüglich der Längsachse 7 aufweisen. Die Querschnittsform hängt vom Querschnitt des herzustellenden Kristalls "K" ab. So kann der Innenquerschnitt z.B. rund, oval oder mehreckig ausgebildet sein. Der mehreckige Querschnitt kann z.B. von einem Quadrat, einem Rechteck, einem Fünfeck, Sechseck, Achteck oder dergleichen gebildet sein.

Die Tiegelwand 4 definiert ihrerseits eine Tiegelwand-Innenfläche 8 und eine Tiegelwand-Außenfläche 9, wobei in radialer Richtung gesehen von den beiden Tiegelwand-Flächen 8 und 9 eine Tiegelwanddicke 10 festgelegt wird.

Zur Bildung eines Aufnahmeraums 11 ist die Tiegelwand 4 bodenseitig in ihrem zweiten Endbereich 6 mit einem Tiegelboden 12 verschlossen auszubilden. Damit definieren die Tiegelwand 4 und der Tiegelboden 12 den Aufnahmeraum 11.

Erfindungsgemäß ist vorgesehen, dass der Tiegelboden 12 ausschließlich aus einer Platte 13 aus einem bereits zuvor künstlich hergestellten Saphir-Kristall "K" gebildet ist.

Damit wird von der den Tiegelboden 12 bildenden Platte 13 ein Keimkristall für den herzustellenden Saphir-Kristall "K" gebildet. Es wurde jeweils die Trennlinie zwischen der Platte 13 und dem bereits neu hergestellten Saphir-Kristall "K" mit einer strichlierten Linie dargestellt, da am Beginn des Aufschmelzvorgangs des Basismaterials 2 und der Bildung der Schmelze "S" die dem Aufnahmeraum 11 zugewendete Oberfläche der Platte 13 zumindest teilweise oder gänzlich aufgeschmolzen wird und bei fortschreitender Abkühlung und Kristallisation ein zusammengehöriger einstückiger Saphir-Kristall "K" ausgebildet wird.

Die den Tiegelboden 12 bildende Platte 13 kann eine Plattenstärke mindestens 1 mm bis zu mehreren mm 14 aufweisen, welche aus einem Plattenstärke-Wertebereich stammt, dessen untere Grenze 0,5mm mm, insbesondere 1 mm, und dessen obere Grenze 5 mm, insbesondere 2 mm, beträgt.

Weiters kann der offene erste Endbereich 5 der Tiegelwand 4 mit einer Wandstärke von 0,5mm bis zu mehreren mm von einem Tiegeldeckel 15 abgedeckt sein. Als möglicher Werkstoff zur Bildung der Tiegelwand 4 und/oder des Tiegeldeckels 15 kann ein Material aus der Gruppe von Iridium (Ir), Wolfram (W), Molybdän (Mo) ausgewählt werden.

Da zumeist der Saphir-Kristall "K" und auch die den Tiegelboden 12 bildenden Platte 13 glasklar bis durchsichtig ausgebildet sind oder werden, besteht die Möglichkeit durch die Platte 13 hindurch die unterschiedlichsten Messungen in den Aufnahmeraum 11 hinein durchzuführen. Dazu ist je nach durchzuführender Messung zumindest ein Sensor 16 vorzusehen. Der zumindest eine Sensor 16 wird auf der vom Aufnahmeraum 11 abgewendeten Seite der den Tiegelboden 12 bildenden Platte 13 angeordnet und ist vereinfacht angedeutet. Der Sensor 16 kann mit einer Steuerungsvorrichtung 17 in Kommunikationsverbindung stehen und den oder die ermittelten Messwerte an diese übertragen.

Der Sensor 16 kann z.B. dafür ausgebildet sein, die relative Lage einer Grenzschicht 18 zwischen dem erstarrten Saphir-Kristall "K" und der sich noch oberhalb befindlichen Schmelze "S" aus dem Basismaterial 2 zu ermitteln. Die vom Sensor 16 ausgesendeten Messstrahlen sind in strichlierten Linien bis hin zur Grenzschicht 18 angedeutet bzw. dargestellt. Es wäre aber auch noch möglich, die Lage der Schmelze-Oberfläche innerhalb des Aufnahmeraums 11 mittels dieses Sensors 16 und/oder aber einem weiteren nicht näher dargestellten Sensor zu ermitteln. Die an der Schmelzeoberfläche endenden Messstrahlen sind bei diesem Ausführungsbeispiel und auch den nachfolgend noch beschriebenen Ausführungsbeispielen jeweils mit strich-punktierten Linien angedeutet. Es wäre aber auch möglich, mit dem gleichen Sensor 16 und der ermittelten unterschiedlichen Laufdauer der Messstrahlen bis hin zur Grenzschicht 18 zwischen dem erstarrten Saphir-Kristall "K" und der sich noch oberhalb befindlichen Schmelze "S" oder bis hin zu der Schmelzeoberfläche die jeweilige Lage oder Höhenposition zu eruieren.

Bei einem Sensor 16, welcher auch als Detektor, Fühler, Messfühler oder Aufnehmer bezeichnet werden kann, handelt es sich um ein technisches Bauteil, das bestimmte physikalische oder chemische Eigenschaften und/oder die stoffliche Beschaffenheit seiner Umgebung qualitativ oder als Messgröße quantitativ erfassen kann. Diese Größen werden mittels physikalischer, chemischer oder biologischer Effekte erfasst und in ein weiterverarbeitbares elektrisches Signal umgeformt und gegebenenfalls an die Steuerungsvorrichtung 17 übertragen. Mittels der Steuerungsvorrichtung 17 kann die Anlage mit der Vorrichtung 1 und der Verfahrensablauf geregelt und gesteuert werden. Der Sensor 16 kann beispielsweise eine Vorrichtung zur Erzeugung eines Laserstrahls (z.B. eine Laserdiode) sowie eine Vorrichtung zum Erfassen eines reflektierten Laserstrahls, beispielsweise eine Fotodiode, insbesondere eine Avalanche Fotodiode (APD) oder einen CCD-Chip, aufweisen. Des Weiteren kann der Sensor 16 weitere elektronische Elemente, wie einen Signalverstärker und Mikro- bzw. Signalprozessor umfassen. Durch eine Laufzeitmessung mittels Laser lässt, beispielsweise sich die aktuelle Lage der Grenzschicht zwischen Schmelze und Kristall erfassen.

Weiters ist noch gezeigt, dass die Tiegelwand 4 bei lotrechter Ausrichtung von deren Längsachse 7 mit ihrem bodenseitigen zweiten Endbereich 6 - nämlich mit deren bodenseitigen Tiegel-Stirnfläche - auf der den Tiegelboden 12 bildenden Platte 13 aus dem bereits zuvor künstlich hergestellten Saphir-Kristall "K" auflagernd abgestützt sein kann. Die Außenabmessung der Platte 13 ist somit größer auszubilden als die von der Tiegelwand-Innenfläche 8 definierte lichte Innenabmessung. So kann z.B. die den Tiegelboden 12 bildende Platte 13 eine Außenabmessung 19 aufweisen, welche maximal einer von der Tiegelwand-Außenfläche 9 definierten Querschnittsabmessung entspricht. Damit kann ein radiales Überragen der Platte über die Außenabmessung der Tiegelwand 4 hinaus verhindert werden. Um die Entformung und eine mögliche Abstützung der Tiegelwand 4 in ihrem bodenseitigen zweiten Endbereich 6 zu ermöglichen, kann, wie in strichlierten Linien angedeutet, die Außenabmessung 19 der Platte 13 kleiner gewählt werden als die von der Tiegelwand-Außenfläche 9 definierte äußere Querschnittsabmessung.

Die Tiegelwand 4 kann weiters mittels der Platte 13 auf einer nicht näher bezeichneten Stützvorrichtung abgestützt werden. Im vorliegenden Ausführungsbeispiel ist die Stützvorrichtung von einzelnen, bevorzugt über den Umfang verteilt angeordneten Stützelementen gebildet. Außerhalb der Tiegelwand 4 ist noch vereinfacht eine Heizvorrichtung 20 schematisch angedeutet, mittels welcher das in den Aufnahmeraum 11 eingebrachte Basismaterial 2 zu einem Schmelzebad aufgeschmolzen und die Schmelze "S" bei deren Abkühlung zu dem herzustellenden Saphir-Kristall "K" auskristallisiert und verfestigt wird.

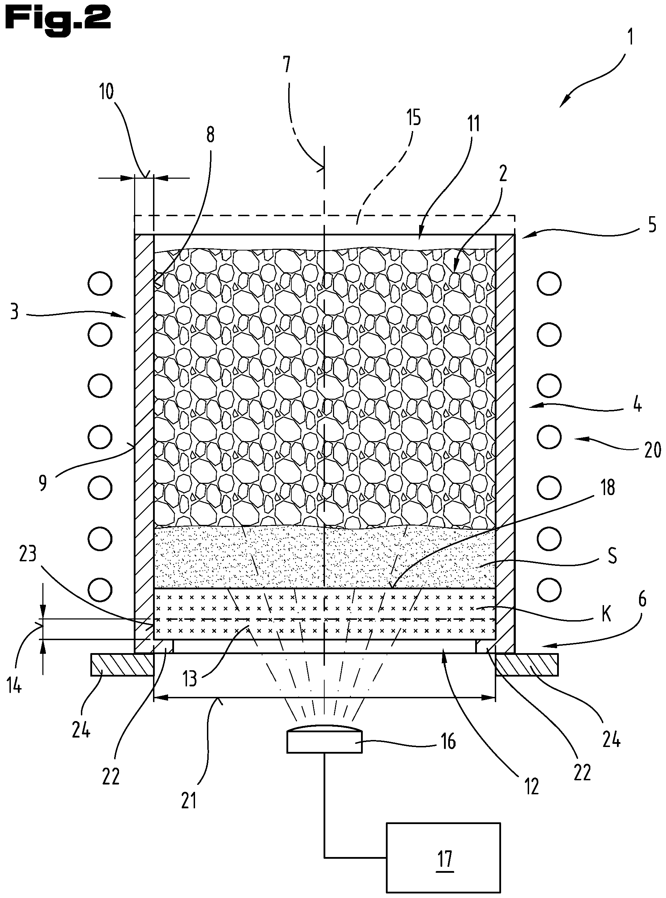

In der Fig. 2 ist ein erfindungsgemäßes und gegebenenfalls für sich eigenständiges Ausführungsbeispiel der Vorrichtung 1 gezeigt, wobei wiederum für gleiche Teile gleiche Bezugszeichen bzw. Bauteilbezeichnungen wie in der vorangegangenen Fig. 1 verwendet werden. Um unnötige Wiederholungen zu vermeiden, wird auf die detaillierte Beschreibung in der vorangegangenen Fig. 1 hingewiesen bzw. Bezug genommen.

Die Vorrichtung 1 umfasst wiederum ebenfalls die Tiegelwand 4, gegebenenfalls den Tiegeldeckel 15 und den aus der kristallinen Platte 13 gebildeten Tiegelboden 12.

Die den Tiegelboden 12 bildende Platte 13 weist hier eine Außenabmessung 19 auf, welche maximal einer von der Tiegelwand-Innenfläche 8 definierten Querschnittsabmessung entspricht. Weiters ist die Platte 13 bodenseitig in den Aufnahmeraum 11 eingesetzt.

Um eine positionierte Halterung der Platte 13 relativ bezüglich der Tiegelwand 4 zu erzielen, können mehrere Halteansätze 22 vorgesehen sein. Die Halteansätze 22 überragen die Tiegelwand-Innenfläche 8 in Richtung auf die Längsachse 7 und sind bevorzugt über den Umfang der Tiegelwand-Innenfläche 8 verteilt angeordnet. Weiters können die Halteansätze 22 einen integralen Bestandteil der Tiegelwand 4 bilden und aus dem selben Werkstoff oder Material wie die Tiegelwand 4 gebildet sein. Unter dem Begriff integral wird hier verstanden, dass die Halteansätze 22 einstückig mit der Tiegelwand 4 ausgebildet sind.

Sind die Halteansätze 22 vorgesehen, ist die den Tiegelboden 12 bildende Platte 13 auf den Halteansätzen 22 auf jeweils deren dem offenen ersten Endbereich 5 zugewendeten Seite auflagernd abgestützt. Die Halteansätze 22 sind zumeist als Vorsprünge oder Ansätze ausgebildet. Es wäre aber auch noch möglich, die Halteansätze 22 durch einen über den Innenumfang durchlaufend ausgebildeten Halteflansch auszubilden.

Die Außenabmessung 19 der den Tiegelboden 12 bildenden Platte 13 ist erfindungsgemäß so gewählt, dass diese mit ihrer äußeren Umfangs-Stirnfläche 23 durchgängig dichtend an der Tiegelwand-Innenfläche 8 anliegt. Die Platte 13 soll flüssigkeitsdicht an der Tiegelwand-Innenfläche 8 anliegen.

Es kann auch hier wiederum der zuvor beschriebene Sensor 16 vorgesehen sein. Da die Platte 13 bevorzugt vollständig in den Aufnahmeraum 11 eingesetzt ist, kann die tragende Abstützung der Tiegelwand 4 mit ihrem bodenseitigen zweiten Endbereich 6 auf zumindest einem Stützelement 24 erfolgen.

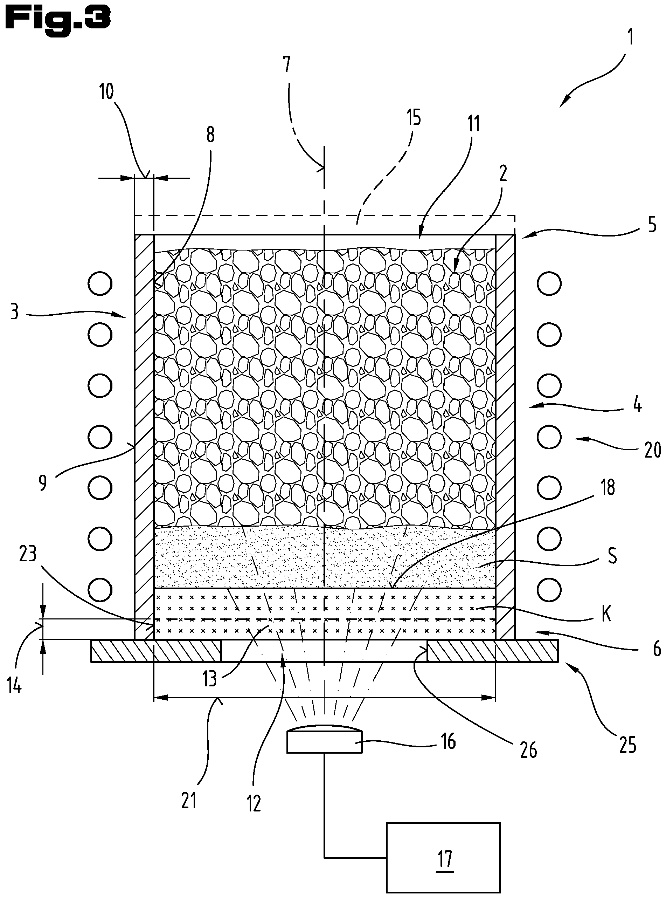

In der Fig. 3 ist eine weitere erfindungsgemäße und gegebenenfalls für sich eigenständige Ausführungsform der Vorrichtung 1 gezeigt, wobei wiederum für gleiche Teile gleiche Bezugszeichen bzw. Bauteilbezeichnungen wie in den vorangegangenen Fig. 1 und 2 verwendet werden. Um unnötige Wiederholungen zu vermeiden, wird auf die detaillierte Beschreibung in den vorangegangenen Fig. 1 und 2 hingewiesen bzw. Bezug genommen.

Die Vorrichtung 1 umfasst wiederum ebenfalls die Tiegelwand 4, gegebenenfalls den Tiegeldeckel 15 und den aus der kristallinen Platte 13 gebildeten Tiegelboden 12.

Die den Tiegelboden 12 bildende Platte 13 weist hier ebenfalls die Außenabmessung 19 auf, welche maximal einer von der Tiegelwand-Innenfläche 8 definierten Querschnittsabmessung entspricht. Weiters ist die Platte 13 bodenseitig in den Aufnahmeraum 11 eingesetzt. Die Außenabmessung 19 der den Tiegelboden 12 bildenden Platte 13 ist erfindungsgemäß so gewählt, dass diese mit ihrer äußeren Umfangs-Stirnfläche 23 durchgängig und dichtend an der Tiegelwand-Innenfläche 8 anliegt. Die Platte 13 soll flüssigkeitsdicht an der Tiegelwand-Innenfläche 8 anliegen.

Im Gegensatz zu dem zuvor in der Fig. 2 beschriebenen Ausführungsbeispiel sind hier keine Halteansätze 22 zur Positionierung der Platte 13 an der Tiegelwand 4 vorgesehen.

Es ist hier vorgesehen, dass die Tiegelwand 4 und die den Tiegelboden 12 bildende Platte 13 gemeinsam auf einer allgemein als Stützvorrichtung 25 bezeichneten Komponente der Vorrichtung 1 auflagernd abgestützt sind. Die Stützvorrichtung 25 kann durch einzelne Stützelemente oder aber auch durch eine Stützplatte gebildet sein. Je nach Ausbildung der Stützvorrichtung 25 weist diese zumindest eine die Stützvorrichtung 25 in Richtung der Längsachse 7 durchdringende Durchsetzung 26 auf. Die zumindest eine Durchsetzung 26 dient dazu, wiederum den Einblick in den Aufnahmeraum 11 von dem zuvor beschriebenen Sensor 16 zu ermöglichen. So kann die Ermittlung oder können die unterschiedlichsten Ermittlungen mit den dazu ausgebildeten Sensoren 16 durchgeführt werden.

So kann nicht nur die relative Lage der zuvor beschriebenen Grenzschicht 18 zwischen dem bereits ausgebildeten Saphir-Kristall "K" und der Schmelze "S" sondern oder zusätzlich dazu die Qualität und/oder Reinheit des bereits ausgebildeten Saphir-Kristall "K" ermittelt werden. Sollte z.B. eine Fehlkristallisation und/oder eine Qualitätsabweichung festgestellt werden, kann der weitere Kristallisationsvorgang und das Aufschmelzen des Basismaterials 2 abgebrochen werden, wodurch ein hoher Anteil an Energiekosten eingespart werden kann.

Durch die im bodenseitigen zweiten Endbereich 6 zum überwiegenden Anteil nicht verschlossene und somit ebenfalls offene Ausbildung der Tiegelwand 4 kann die Entnahme des fertig hergestellten und auskristallisierten Saphir-Kristalls "K" entweder durch den bodenseitig offen ausgebildeten zweiten Endbereich 6 hindurch, wie in den Fig. 1 und 3 gezeigt und beschrieben, oder aber durch eine bodenseitig aufgebrachte Druckkraft (Entformungskraft) auf den fertig hergestellten und auskristallisierten Saphir-Kristall "K" in Richtung auf den offenen ersten Endbereich 5 aus der Tiegelwand 4 heraus entformt werden.

Das Verfahren zum Züchten des künstlich hergestellten Saphir-Kristalls "K" kann bevorzugt unter Verwendung oder Anwendung der Vorrichtung 1 mit der Tiegelwand 4 und der den Tiegelboden 12 bildenden Platte 13 aus dem kristallinen Material als Keimkristall durchgeführt werden. Alternativ zu den in den Figuren 1 bis 3 gezeigte Tiegeln kann auch ein Tiegel mit einem geschlossenen Boden Verwendung finden, wobei der Keimkristall bzw. die Platte 13 dann in den Tiegel eingesetzt wird.

Es sind dabei zumindest folgende Schritte zur Durchführung des Verfahrens vorgesehen:
Anordnen eines einkristallinen Keimkristalls aus Saphir in einem Bodenbereich des Tiegels 3 und Ausrichten einer kristallographische c-Achse des Keimkristalls bzw. der Platte 13 entsprechend einer sich in Richtung der Höhe der Tiegelwand 4 erstreckende Längsachse 7 des Tiegels. Unter der kristallographischen c-Achse wird hierbei die optische Achse des Kristalls verstanden, entlang derer jede Polarisationskomponente eines Lichtstrahls den gleichen Brechungsindex erfährt. Anordnen des Basismaterials 2, insbesondere Al₂O₃, in dem Tiegel 3 auf dem Keimkristall und Aufschmelzen des Basismaterials 2, wobei ein Kristallwachstum durch Kristallisation an einer Grenzschicht zwischen aufgeschmolzenen Basismaterial 2 und Keimkristall in Richtung der c-Achse fortschreitend erfolgt. Der Keimkristalls wird bevorzugt so angeordnet, dass seine c-Achse mit der Längsachse des Tiegels zusammenfallend angeordnet wird.

Der Keimkristall ist im Wesentlichen scheibenförmig ausgebildet, wobei die c-Achse des Keimkristalls mit der Längsmittelachse des Keimkristalls zusammenfällt. Bevorzugt ist es vorgesehen, dass der Keimkristalls eine Krümmung aufweist, die einen höchsten Punkt sowie einen tiefsten Punkt bezüglich der Längsmittelachse aufweist, wobei ein Abstand zwischen dem höchsten Punkt und dem tiefsten Punkt der Krümmung bezüglich der Längsmittelachse weniger als 7µm beträgt. Die Krümmung des Keimkristalls kann hierbei konkav oder konvex ausgebildet sein. Die Krümmung bezieht sich hierbei auf die Krümmung eines Impfkristalls, d.h. nach einem einseitigen oder beidseitigen Polieren des Keimkristalls. Die Position der c-Achse kann auf dem Keimkristall, insbesondere auf dessen der Kristallwachstumsrichtung abgewandten Seite markiert sein, beispielsweise mit einem Punkt oder einer Einkerbung. Auch auf der dem Keimkristall gegenüberliegenden Oberfläche des fertigen Ingot kann die Position der c-Achse entsprechend markiert werden. Weiters können die Positionen der Wafer auf dem fertigen Ingot markiert werden, sodass ein Herausschneiden der Wafer aus dem Ingot vereinfacht wird.

An dieser Stelle sei darauf hingewiesen, dass auch mehrere Kristalle gleichzeitig in einem Ofen gezüchtet werden können, indem mehrere Tiegel 3 in dem Ofen angeordnet werden. Werden mehrere Kristalle gleichzeitig in einem Ofen gezüchtet, so wird das hier beschriebene Verfahren für jeden Kristall durchgeführt. Die gleichzeitige Zucht mehrerer Kristalle in einem Ofen ist vor allem hinsichtlich des Energiebedarfs vorteilhaft.

Der Tiegel 3 bzw. mehrere Tiegel 3 ist bzw. sind in einem Ofen angeordnet. In dem Ofen ist zumindest ein Heizelement angeordnet. Das zumindest eine Heizelement dient dazu, die Tiegelfüllung zu schmelzen, wie dies an sich bekannt ist. Insbesondere ist zumindest ein Heizelement oberhalb des Tiegels 3 bzw. der Tiegel angeordnet. Es können aber auch noch weitere Heizelemente vorgesehen sein, die seitlich von der Tiegelwand 4 bzw. der Tiegelwände 4 angeordnet sind. Es können über den Umfang des Tiegels 3 bzw. der Tiegel 3 verteilt auch mehrere Heizelemente angeordnet sein. Die Heizelemente können den Stand der Technik entsprechend ausgebildet sein, beispielsweise als Widerstandsheizelemente oder als induktive Heizelemente.

Vor dem Aufheizen und Schmelzen des Basismaterials 2 kann ein Spülen des Ofens bzw. der Kammer des Ofens, in welcher sich der bzw. die Tiegel 3 befindet bzw. befinden mittels eines Gases erfolgen. Hierauf kann das Gas abgepumpt und ein Prozessdruck eingestellt werden. Bevor der Prozess gestartet und das Basismaterial 2 durch Erhitzen zum Schmelzen gebracht wird, kann ein Feuchtigkeitsgehalt des abgepumpten Gas bestimmt werden. Das Aufheizen und Schmelzen des Rohmaterials erfolgt erst bei Unterschreiten eines Schwellwertes des Feuchtigkeitsgehaltes. Zur Bestimmung des Feuchtigkeitsgehalts des abgepumpten Gases kann beispielsweise ein Massenspektrometer verwendet werden. Alternativ oder zusätzlich können auch kapazitive Methoden zum Einsatz kommen.

Während des Prozesses kann beginnend mit dem Schritt des Kristallwachstums zwischen einer Schmelzeoberfläche, insbesondere einer Al₂O₃-Schmelzeoberfläche und der Grenzoberfläche des wachsenden Einkristalls, insbesondere Saphir-Einkristalls zur Al₂O₃-Schmelze eine Temperaturdifferenz ΔT wenigstens über eine überwiegende Dauer des Kristallwachstums konstant gehalten werden.

Da der Tiegel 3 bzw. die Tiegel 3 von dem Keimkristall aus betrachtet nach oben offen ist bzw. sind, wenn der Deckel 15 entfernt wird, kann bei nicht abgedecktem Tiegel 3 bzw. Tiegeln 3 ein Spiegel einer Schmelze des Basismaterial mittels zumindest eines in Fig.1 mit dem Bezugszeichen 28 bezeichneten Heizelements, welches über einer offenen Seite des Tiegels 3 bzw. der Tiegel 3 angeordnet werden kann von oben direkt erwärmt werden, wobei zwischen dem Heizelement 28 und der offenen, oberen Seite des Tiegels 3 bzw. der Tiegel 3 bevorzugt ein Wärmediffusorelement 27, beispielsweise eine Diffusorplatte, zur Herstellung eines gleichmäßigen Wärmeverteilung direkt an dem Heizelement 28 angeordnet sein kann. Bevorzugt kann die Diffusorplatte aus Graphit hergestellt sein.

Weiters kann die Tiegelwand 4 des Tiegels 3 bzw. der Tiegel 3 über ihre gesamte Erstreckung eine gleichbleibende Wärmeleitfähigkeit und/oder gleiche optische und/oder gleiche mechanische Eigenschaften aufweist. Die Tiegelwand 4 kann an ihrer Tiegel-Innenwand 8 auch eine gleichartige Oberflächenausbildung aufweisen. Weiters kann die zylinderförmige Tiegelwand 4 in sich ringförmig geschlossen und nahtlos ausgebildet sein sowie über ihre gesamte Erstreckung einen gleichartigen strukturellen Aufbau aufweisen. Die Tiegelwand 4 weist somit bevorzugt keine von oben nach unten erstreckende Füge-bzw. Verbindungsstelle auf.

Durch die nahtlose und homogene Ausbildung der Tiegelwand 4 wird eine lokale Schwächung des Materials, wie sie eine Schweißnaht darstellt, vermieden. Insbesondere kann dadurch vermieden werden, dass sich entlang der Schweißnaht Fehlstellen in dem Einkristall während des Kristallwachstums bilden. Besonders geeignet zur Herstellung der Tiegelwand 4 ist ein Schleudergussverfahren. Die Tiegelwand 4 kann dann später mit dem Tiegelboden 12 verbunden werden.

Der herzustellende Einkristall weist vorzugsweise einen Außendurchmesser bzw. eine Querschnittsfläche auf, der dem Innendurchmesser bzw. der Innengeometrie des Tiegels 3 entspricht. Somit füllt der entstehende Einkristall bevorzugt die Querschnittsfläche des Tiegels 3 zur Gänze aus. Der Einkristall wird also bevorzugt nicht aus dem Tiegel gezogen. Der fertige Einkristall kann beispielsweise einen Durchmesser zwischen 5 cm und 50 cm und eine Höhe zwischen 5 cm und 80 cm aufweisen. Es sei jedoch darauf hingewiesen, dass diese Werte der Veranschaulichung dienen und den Schutzumfang nicht beschränkend verstanden werden sollen.

Durch Schneiden quer zur Längsachse 7 lässt sich der erhaltene Einkristall Ingot in Wafer schneiden, die im Wesentlichen scheibenförmig ausgebildet ist,
- eine erste Flachseite und eine zweite Flachseite aufweisen;
- eine Längsmittelachse aufweisen, welche Längsmittelachse in Richtung von der ersten
Flachseite zur zweiten Flachseite ausgebildet ist,
wobei zumindest eine Flachseite eine Krümmung aufweist; welche Krümmung einen höchsten Punkt sowie einen tiefsten Punkt bezüglich der Längsmittelachse aufweist;
wobei ein Abstand zwischen dem höchsten Punkt und dem tiefsten Punkt der Krümmung bezüglich der Längsmittelachse des Substrats nach dem Schleifen und Polieren weniger als 7µm beträgt.

Die Längsmittelachse des Wafers ist ebenfalls durch die C-Achse gebildet. Die Krümmung des Wafers kann konkav oder konvex ausgebildet sein.

Mittels des zuvor beschriebenen Sensors 16, gegebenenfalls in Kombination mit der Steuerungsvorrichtung 17, kann vom Sensor 16 durch die den Tiegelboden 12 bildenden Platte 13 hindurch z.B. die relative Lage der Grenzschicht 18 zwischen dem bereits erstarrten Saphir-Kristall "K" und der Schmelze "S" ermittelt werden.

Dies deshalb, da die den Keimkristall bildende Kristall-Platte zumindest durchsichtig oder durchscheinend bis hin zu glasklar ausgebildet ist. Deshalb wird ein Durchtritt von Sensor 16 ausgesendeten oder abgegebenen Messstrahlen durch die Platte 13 hindurch ermöglicht.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

### Bezugszeichenaufstellung

- 1: Vorrichtung
- 2: Basismaterial
- 3: Tiegel
- 4: Tiegelwand
- 5: erster Endbereich
- 6: zweiter Endbereich
- 7: Längsachse
- 8: Tiegelwand-Innenfläche
- 9: Tiegelwand-Außenfläche
- 10: Tiegelwanddicke
- 11: Aufnahmeraum
- 12: Tiegelboden
- 13: Platte
- 14: Plattenstärke
- 15: Tiegeldeckel
- 16: Sensor
- 17: Steuerungsvorrichtung
- 18: Grenzschicht
- 19: Außenabmessung
- 20: Heizvorrichtung
- 21: Außenabmessung
- 22: Halteansätze
- 23: Umfangs-Stirnfläche
- 24: Stützelement
- 25: Stützvorrichtung
- 26: Durchsetzung
- 27: Wärmediffusorelement
- 28: Heizelement

## Patentansprüche

1. Vorrichtung (1) zum Züchten zumindest eines künstlich hergestellten Saphir-Einkristalls, umfassend
- zumindest eine Tiegelwand (4), welche Tiegelwand (4) einen offenen ersten Endbereich (5) und einen in Richtung einer Längsachse (7) davon beabstandet angeordneten bodenseitigen zweiten Endbereich (6) aufweist, wobei von der zumindest einen Tiegelwand (4) im Querschnitt bezüglich der Längsachse (7) gesehen eine Tiegelwand-Innenfläche (8) und in einer Tiegelwanddicke (10) davon beabstandet eine Tiegelwand-Außenfläche (9) definiert ist,
- zumindest einen Tiegelboden (12), welcher Tiegelboden (12) im bodenseitigen zweiten Endbereich (6) angeordnet ist, und
- wobei von der zumindest einen Tiegelwand (4) und dem zumindest Tiegelboden (12) ein Aufnahmeraum (11) zur Bildung des Einkristalls definiert ist,
wobei
die zumindest eine Tiegelwand (4) über ihre gesamte Erstreckung eine gleichbleibende Wärmeleitfähigkeit und/oder gleiche mechanische Eigenschaften aufweist, **dadurch gekennzeichnet, dass** der Tiegelboden (12) ausschließlich aus einer als Keimkristall dienenden Platte (13) aus einem zuvor künstlich hergestellten Saphir-Kristall gebildet ist, wobei eine Außenabmessung (19) der den Tiegelboden (12) bildenden Platte (13) so gewählt ist, dass diese mit einer äußeren Umfangs-Stirnfläche (23) durchgängig dichtend an der Tiegelwand-Innenfläche (8) anliegt.

2. Vorrichtung nach Anspruch 1, **dadurch gekennzeichnet, dass** die Tiegelwand-Innenfläche (8) über ihre ganze Fläche eine gleichartige Oberflächenausbildung aufweist.

3. Vorrichtung nach Anspruch 1 oder 2, **dadurch gekennzeichnet, dass** die Tiegelwand (4) in sich ringförmig geschlossen und nahtlos ausgebildet ist.

4. Vorrichtung nach einem der Ansprüche 1 bis 3, **dadurch gekennzeichnet, dass** die Tiegelwand (4) über ihre gesamte Erstreckung einen gleichartigen strukturellen Aufbau aufweist.

5. Vorrichtung nach einem der Ansprüche 1 bis 4, **dadurch gekennzeichnet, dass** die Tiegelwand (4) aus Iridium (Ir), Wolfram (W) oder Molybdän (Mo) hergestellt ist.

6. Vorrichtung nach einem der Ansprüche 1 bis 5, **dadurch gekennzeichnet, dass** die Tiegelwand (4) durch ein Schleudergussverfahren hergestellt ist.

7. Vorrichtung nach einem der Ansprüche 1 bis 6, **dadurch gekennzeichnet, dass** der Tiegel (3) nach oben hin offen ist und über dem Tiegel (3) zumindest ein oberes Heizelement (28) angeordnet ist, wobei zwischen dem oberen Heizelement und dem Tiegel (3) ein Wärmediffusorelement (27) zur Erzeugung einer gleichmäßigen Wärmeverteilung angeordnet ist.

8. Vorrichtung nach einem der Ansprüche 1 bis 7, **dadurch gekennzeichnet, dass** eine kristallographische c-Achse des Keimkristalls entsprechend einer sich in Richtung der Höhe der Tiegelwand erstreckende Längsachse (7) des Tiegels (3) ausgerichtet ist.

9. Vorrichtung nach Anspruch 8, **dadurch gekennzeichnet, dass** die c-Achse des Keimkristalls mit der Längsachse (7) des Tiegels (3) zusammenfällt.

10. Vorrichtung nach einem der Ansprüche 1 bis 9, **dadurch gekennzeichnet, dass** der Keimkristall im Wesentlichen scheibenförmig ausgebildet ist,
- eine Längsmittelachse aufweist, wobei die c-Achse des Keimkristalls mit der Längsmittelachse des Keimkristalls zusammenfällt.

## Claims

1. Device (1) for growing at least one artificially manufactured sapphire single crystal, comprising
- at least one crucible wall (4), said crucible wall (4) having an open first end portion (5) and a base-side second end portion (6) arranged at a distance from the first end portion along a longitudinal axis (7), wherein when viewed from the at least one crucible wall (4) in cross-section in relation to the longitudinal axis (7) a crucible wall inner surface (8) is defined, and at a distance of one wall thickness (10) thereto a crucible wall outer surface (9) is also defined,
- at least one crucible base (12), said crucible base (12) being arranged in the base-side second end portion (6), and
- wherein a receiving area (11) for the formation of the single crystal is defined by the at least one crucible wall (4) and the at least one crucible base (12),
wherein
the at least one crucible wall (4) has constant thermal conductivity and/or identical mechanical properties over its entire extension, **characterized in that** the crucible base (12) is formed exclusively from a plate (13) made from a previously manufactured sapphire crystal serving as a seed crystal, wherein an external dimension (19) of the plate (13) that forms the crucible base (12) is selected such that an outer circumferential front surface (23) is constantly in contact and forms a seal with the inner crucible wall surface (8) .

2. Device according to Claim 1, **characterized in that** the crucible wall inner surface (8) has a similar surface configuration across its entire surface.

3. Device according to Claim 1 or 2, **characterized in that** the crucible wall (4) is closed on itself in an annular and seamless configuration.

4. Device according to one of Claims 1 to 3, **characterized in that** the crucible wall (4) has a similar structural composition across its entire extension.

5. Device according to one of Claims 1 to 4, **characterized in that** the crucible wall (4) is made from iridium (Ir), tungsten (W) or molybdenum (Mo).

6. Device according to one of Claims 1 to 5, **characterized in that** the crucible wall (4) is produced using a centrifugal casting method.

7. Device according to one of Claims 1 to 6, **characterized in that** the crucible (3) is open upwardly and at least one upper heating element (28) is arranged above the crucible (3), wherein a thermal diffuser element (27) for ensuring even heat distribution is arranged between the upper heating element and the crucible (3).

8. Device according to one of Claims 1 to 7, **characterized in that** a crystallographic c-axis of the seed crystal is aligned in accordance with a longitudinal axis (7) of the crucible (3) extending up the crucible wall.

9. Device according to Claim 8, **characterized in that** the c-axis of the seed crystal is coincidental with the longitudinal axis (7) of the crucible (3).

10. Device according to one of Claims 1 to 9, **characterized in that** the seed crystal is substantially disc-shaped,
- having a longitudinal centre axis, wherein the c-axis of the seed crystal is coincidental with the longitudinal centre axis of the seed crystal.

## Revendications

1. Dispositif (1) permettant de faire croître au moins un monocristal de saphir produit de manière artificielle, comprenant
- au moins une paroi de creuset (4), laquelle paroi de creuset (4) présente une première région d'extrémité (5) ouverte et une deuxième région d'extrémité (6) située côté fond et agencée à distance de ladite première région dans le sens d'un axe longitudinal (7), dans lequel une surface intérieure de paroi de creuset (8) et une surface extérieure de paroi de creuset (9) sont définies, ladite surface extérieure de paroi de creuset étant séparée de ladite surface intérieure de paroi de creuset par une épaisseur de paroi de creuset (10) lorsqu'on les considère par rapport à l'axe longitudinal (7) en coupe transversale de la au moins une paroi de creuset (4),
- au moins un fond de creuset (12), lequel fond de creuset (12) est agencé dans la deuxième région d'extrémité (6) située côté fond, et
- dans lequel une chambre de réception (11) permettant de former le monocristal est définie par la au moins une paroi de creuset (4) et le au moins un fond de creuset (12), dans lequel
la au moins une paroi de creuset (4) présente une conductivité thermique constante et/ou des propriétés mécaniques identiques sur la totalité de son étendue, **caractérisé en ce que** le fond de creuset (12) est formé exclusivement d'une plaque (13) servant de germe cristallin et constituée d'un cristal de saphir préalablement produit de manière artificielle, dans lequel une dimension extérieure (19) de la plaque (13) formant le fond de creuset (12) est choisie de sorte que la surface frontale périphérique extérieure (23) de ladite plaque repose de manière constamment étanche contre la surface intérieure de paroi de creuset (8).

2. Dispositif selon la revendication 1, **caractérisé en ce que** la surface intérieure de paroi de creuset (8) présente une configuration de surface similaire sur la totalité de sa surface.

3. Dispositif selon la revendication 1 ou 2, **caractérisé en ce que** la paroi de creuset (4) est refermée sur elle-même en forme d'anneau et est réalisée sans soudure.

4. Dispositif selon l'une quelconque des revendications 1 à 3, **caractérisé en ce que** la paroi de creuset (4) présente une organisation structurelle similaire sur la totalité de son étendue.

5. Dispositif selon l'une quelconque des revendications 1 à 4, **caractérisé en ce que** la paroi de creuset (4) est produite à partir d'iridium (Ir), de tungstène (W) ou de molybdène (Mo).

6. Dispositif selon l'une quelconque des revendications 1 à 5, **caractérisé en ce que** la paroi de creuset (4) est produite grâce à un procédé de coulée par centrifugation.

7. Dispositif selon l'une quelconque des revendications 1 à 6, **caractérisé en ce que** le creuset (3) est ouvert vers le haut et **en ce qu'**au moins un élément de chauffage supérieur (28) est agencé au-dessus du creuset (3), dans lequel un élément de diffusion de chaleur (27) permettant de produire une répartition uniforme de chaleur est agencé entre l'élément de chauffage supérieur et le creuset (3).

8. Dispositif selon l'une quelconque des revendications 1 à 7, **caractérisé en ce qu'**un axe cristallographique c du germe cristallin est orienté selon un axe longitudinal (7) du creuset (3) s'étendant dans le sens de la hauteur de la paroi de creuset.

9. Dispositif selon la revendication 8, **caractérisé en ce que** l'axe c du germe cristallin coïncide avec l'axe longitudinal (7) du creuset (3).

10. Dispositif selon l'une quelconque des revendications 1 à 9, **caractérisé en ce que** le germe cristallin est réalisé essentiellement en forme de disque,
- présente un axe longitudinal médian, dans lequel l'axe c du germe cristallin coïncide avec l'axe longitudinal médian du germe cristallin.
